# EUROPEAN PATENT APPLICATION

(11) **EP 2 383 800 A2**
(43) Date of publication of application: **02.11.2011**
(21) Application number: 11163305.3
(22) Date of filing: 20.04.2011
(51) Int. Cl.: H01L 31/072

(54) **Photovoltaic cells with cadmium telluride intrinsic layer**

(30) Priority: 28.04.2010 US 768929
(71) Applicant: General Electric Company, Schenectady, NY 12345 (US)
(72) Inventor: Korevaar, Bastiaan Arie, Niskayuna, NY 12309 (US)
(74) Representative: Bedford, Grant Richard

(57) **Abstract**

A photovoltaic (PV) cell (10) includes a first electrically conductive layer (12), a p-type semiconductor layer (14), and a substantially intrinsic semiconductor layer (16) with a median grain size of at least about five (5) µm and comprising a cadmium and tellurium. The PV cell further includes an n-type semiconductor layer (18) and a second electrically conductive layer (22). The substantially intrinsic semiconductor layer is disposed between the p-type semiconductor layer and the n-type semiconductor layer. A photovoltaic cell (10) that includes a first electrically conductive layer (12) comprising a textured substrate and a substantially intrinsic semiconductor layer (16), with a median grain size of at least about five (5) µm and comprising cadmium and tellurium, is also provided.

## Description

The invention relates generally to photovoltaic cells and, more particularly, to photovoltaic (PV) cells with intrinsic layers comprising cadmium and tellurium.

PV (or solar) cells are used for converting solar energy into electrical energy. Typically, in its basic form, a PV cell includes a semiconductor junction made of two or three layers that are disposed on a substrate layer, and two contacts (electrically conductive layers) for passing electrical energy in the form of electrical current to an external circuit. Moreover, additional layers are often employed to enhance the conversion efficiency of the PV device.

There are a variety of candidate material systems for PV cells, each of which has certain advantages and disadvantages. CdTe is a prominent polycrystalline thin-film material, with a nearly ideal bandgap of about 1.45-1.5 electron volts. CdTe also has a very high absorptivity, and films of CdTe can be manufactured using low-cost techniques. Although CdTe has the potential to achieve relatively high efficiencies (cell efficiencies greater than 16%), commercially produced CdTe modules typically have efficiencies in the 9-11% range. These relatively low power conversion efficiencies may be attributed to a relatively low open circuit voltage (V_{oc}) in relation to the bandgap of the material, which is due, in part, to the low effective carrier concentration and short minority carrier lifetime in CdTe. As known to those skilled in the art, V_{OC} is the potential between the anode and cathode with no current flowing. At V_{OC} all the electrons and holes recombine within the device. Accordingly, V_{OC} sets an upper limit for the work that can be extracted from a single electron-hole pair.

The short minority carrier lifetime that is typically exhibited by thin film CdTe devices may be attributed to the high defect density that occurs when thin film CdTe is grown at relatively low temperatures (500-550 C) using close-spaced sublimation (or CSS). The high defect density results in the presence of donor and acceptor states that off-set each other, resulting in an effective carrier density in the 10¹¹ to 10¹³ per cubic centimeter (cc) range. However, the effective carrier density could be increased, for example by performing a CdCl₂ treatment to the as-grown CdTe film, to achieve effective carrier densities in the 10¹³ to 10¹⁵ per cc range. Typical minority carrier lifetimes in these devices are less than about 1 nanosecond (ns). A combination of those two numbers will limit the Voc of these types of devices to around 850 mV, whereas V_{OC} values on the order of one Volt (V) should be achievable if these properties could be improved or when going to a different device design. See for example, James Sites, Jun Pan, "Strategies to increase CdTe solar-cell voltage," Thin Solid Films, Volume 515, Issue 15, Pages 6099-6102.

It would therefore be desirable to reduce the defect density for CdTe PV cells. It would further be desirable to provide CdTe PV cells with higher effective carrier concentration and increased minority carrier lifetimes. Also, where higher effective carrier densities cannot be achieved, it would be desirable to provide a different CdTe PV device design.

One aspect of the present invention resides in a photovoltaic cell that includes a first electrically conductive layer, a p-type semiconductor layer, and a substantially intrinsic semiconductor layer with a median grain size of at least about five (5) µm and comprising cadmium and tellurium. The photovoltaic cell further includes an n-type semiconductor layer and a second electrically conductive layer. The substantially intrinsic semiconductor layer is disposed between the p-type semiconductor layer and the n-type semiconductor layer.

Another aspect of the present invention resides in a photovoltaic cell that includes a first electrically conductive layer comprising a textured substrate, a p-type semiconductor layer, and a substantially intrinsic semiconductor layer with a median grain size of at least about five (5) µm and comprising cadmium and tellurium. The photovoltaic cell further includes an n-type semiconductor layer and a second electrically conductive layer. The substantially intrinsic layer is disposed between the p-type semiconductor layer and the n-type semiconductor layer.

Various features, aspects, and advantages of the present invention will become better understood when the following detailed description is read with reference to the accompanying drawings in which like characters represent like parts throughout the drawings, wherein:
FIG. 1 is a schematic cross-sectional diagram of an example photovoltaic cell with an n-i-p structure, in accordance with various embodiments of the present invention;
FIG. 2 is a schematic cross-sectional diagram of an example photovoltaic cell with an n-i-p structure and a high resistance transparent conductive oxide (HRT) layer, in accordance with various embodiments of the present invention;
FIG. 3 is a schematic cross-sectional diagram of an example photovoltaic cell with an n-i-p structure and an insulating layer and a metal layer disposed between the first electrically conductive layer and the photovoltaic active layers, in accordance with various embodiments of the present invention;
FIG. 4 is a schematic cross-sectional diagram of another example photovoltaic cell with a p-i-n structure, in accordance with various embodiments of the present invention; and
FIG. 5 is a schematic cross-sectional diagram of an example photovoltaic cell with a p-i-n structure and an insulating layer and a metal layer disposed between the first electrically conductive layer and the photovoltaic active layers, in accordance with various embodiments of the present invention.

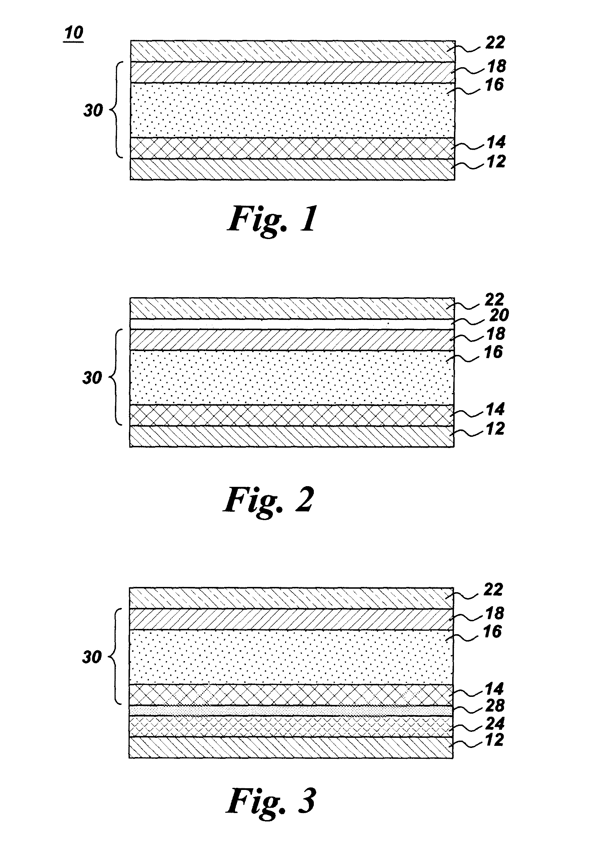

A photovoltaic cell 10 embodiment of the invention is described with reference to FIGS. 1-3. As indicated in FIG. 1, the photovoltaic (PV) cell 10 includes a first electrically conductive layer 12, a p-type semiconductor layer 14, and a substantially intrinsic (i-type) semiconductor layer 16. The substantially intrinsic semiconductor layer 16 comprises cadmium and tellurium, and more particularly, comprises a material selected from the group consisting of cadmium telluride (CdTe), cadmium zinc telluride, cadmium sulfur telluride, cadmium manganese telluride, cadmium magnesium telluride and combinations thereof and comprises a number of grains separated by grain boundaries and has a median grain size of at least about five (5) µm. The grains are either p-type or n-type. As used here, the phrase "substantially intrinsic" should be understood to denote a material with a carrier concentration of less than about 10¹³ per cubic centimeter (cc). As will be recognized by those skilled in the art, carrier concentrations in this range can be achieved for both actively doped material and material formed without the active introduction of dopants. Non-limiting examples of n-type dopants for CdTe include aluminum, indium, chlorine, bromine and iodine. For CdTe, suitable p-type dopants include, without limitation, copper, nitrogen, phosphorus, antimony, arsenic and sodium.

For certain configurations, the intrinsic semiconductor layer 16 comprises cadmium telluride (CdTe). However, the intrinsic semiconductor layer 16 may, in certain embodiments, comprise other elements from the Group II and Group VI or Group III and Group V that will not result in large bandgap shifts (for example, bandgap shifts that are ≤ 0.1 eV), such as zinc, sulfur, manganese and magnesium. For specific configurations, the atomic percent of cadmium in the CdTe is in the range from about 48-52 atomic percent, and the atomic percent of tellurium in the CdTe is in the range from about 45-55 atomic percent. The CdTe employed may be Te-rich, for example the atomic percent of tellurium may be in the range from about 52-55 atomic percent. For specific configurations, the atomic percent of zinc, sulfur, manganese, or magnesium in the CdTe is less than about 10 atomic percent, and more particularly, about 8 atomic percent, and still more particularly, about 6 atomic percent, with the bandgap staying in the 1.4-1.5 eV range. It has been postulated that by adding a small atomic percent of zinc, the defect density of the resulting intrinsic cadmium zinc telluride is reduced relative to CdTe. However, it is possible that instead the defect state may shift to a different energy level within the band, resulting in a different self-compensating level, e.g., may result in more donor/acceptor type states, or a less deep defect, that may improve the lifetime. However, ten atomic percent of zinc will bring the bandgap up to about 1.55 eV. Similarly, the addition of sulfur will vary the bandgap of the resulting intrinsic cadmium sulfur telluride between about 1.4 and 1.5 eV, for small atomic S percentages. See, for example, D.W. Lane, "A review of the optical band gap of thin film CdSxTe1_x ," Solar Energy Materials & Solar Cells 90 (2006) 1169-1175, and Jihua Yang et al., "Alloy composition and electronic structure of CdlkxZnxTe by surface photovoltage spectroscopy," Journal of Applied Physics, Vol. 91, No. 2, p. 703-707.

As indicated in FIG. 1, the PV cell 10 further includes an n-type semiconductor layer 18 and a second electrically conductive layer 22. For the arrangements shown in FIGS. 1-3, the first electrically conductive layer 12 is disposed below the p-type semiconductor layer 14. The substantially intrinsic semiconductor layer 16 is disposed between the p-type semiconductor layer 14 and the n-type semiconductor layer 18, thereby forming an n-i-p structure 30. The n-type semiconductor layer 18 is disposed below the second electrically conductive layer 22, for the configurations shown in FIGS. 1-3, such that light is incident through the n-type semiconductor layer 18.

As known in the art, carrier pairs generated in the substantially intrinsic CdTe layer are separated by an internal field generated by the respective doped layers, so as to create the photovoltaic current. In this manner, the n-i-p structure, when exposed to appropriate illumination, generates a photovoltaic current, which is collected by the electrically conductive layers 12, 22, which are in electrical communication with appropriate layers of the device.

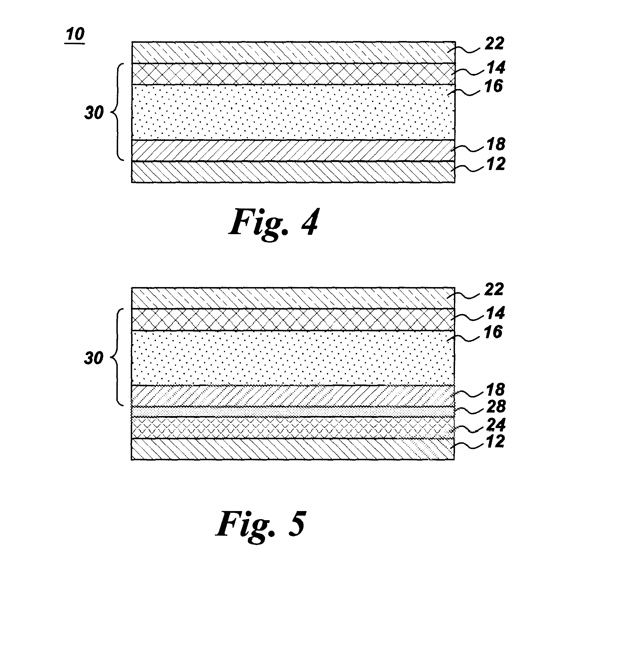

Another PV cell embodiment (also indicated by reference numeral 10) is shown in FIGS. 4 and 5. The PV cells 10 shown in FIGS. 4 and 5 are similar to those of FIGS. 1 and 3, except that the p- and n-type semiconductor layers are reversed, such that the PV cells 10 shown in FIGS. 4 and 5 have a p-i-n structure, where light enters through the p-type semiconductor layer 14, and the n-type semiconductor layer is at the back of the cell. Thus, for the configurations of FIGS. 4 and 5, the p-type semiconductor layer 14 is the window layer, and light enters through this p-type window layer. For the intrinsic material, it can be beneficial to have the light enter through the p-type semiconductor layer, as hole-mobility is lower than electron mobility.

For the configurations shown in FIGS. 1-3, where the p-type semiconductor layer 14 is at the back of the device, there is no real limitation on the p-type semiconductor layer thickness. Instead, the p-type semiconductor layer may be just thick enough to be 'present' and thin enough to not contribute to the resistance. However, for the configurations shown in FIGS. 4 and 5, where light enters through the p-type semiconductor layer 14, the thickness of the p-type semiconductor layer 14 needs to be minimized, although it must be thick enough to be electrically present to generate the electric field in the intrinsic layer. For the configurations shown in FIGS. 4 and 5, the ratio of the thickness of the intrinsic layer to the thickness of the p-type semiconductor layer ratio is greater than 5:1 for certain examples, and for particular examples is about 20:1.

For certain arrangements, the second electrically conductive layer 22 comprises a transparent conductive oxide (TCO). Non-limiting examples of transparent conductive oxides include indium tin oxide (ITO), fluorine-doped tin oxide (SnO:F) or FTO, indium-doped cadmium-oxide, cadmium stannate (Cd₂SnO₄) or CTO, and doped zinc oxide (ZnO), such as aluminum-doped zinc-oxide (ZnO:Al) or AZO, indium-zinc oxide (IZO), and zinc tin oxide (ZnSnOₓ), and combinations thereof. Depending on the specific TCO employed (and on its sheet resistance), the thickness of the TCO layer 22 may be in the range of about 50-500 nm and, more particularly, 100-200 nm.

Traditionally, the performance of a CdTe-based device has been explained by assigning bulk properties to the CdTe. However, there are increasing indications that the device performance is primarily controlled by the properties of the grain boundaries. For particular embodiments, at least ninety percent (90%) of the grains (in cross-sectional view) within the substantially intrinsic CdTe layer 16 are characterized by a grain size of at least about five (5) µm. In addition, for certain configurations, the substantially intrinsic semiconductor layer 16 has a thickness of less than two (2) µm. For more particular configurations, the ratio of the median grain size for the substantially intrinsic semiconductor layer 16 to the thickness of the substantially intrinsic semiconductor layer 16 is greater than two, and more particularly, greater than five, and still more particularly, greater than ten. In one non-limiting example, the ratio of the median grain size to the thickness of the substantially intrinsic semiconductor layer is about 2.5. Beneficially, by controlling this ratio, the grain-boundaries are relatively far away, such that the charge carriers are more likely to encounter one of the front and back contacts than a grain boundary, especially in a drift device.

To avoid formation of a potential barrier at the P-I interface, the material for the p-type semiconductor layer 14 should be selected to avoid a bandgap discontinuity between the p-type and intrinsic layers. For example, ΔEg< 0.05 eV at the interface between the intrinsic and p-type materials. Non-limiting example materials for the p-type semiconductor layer 14 include zinc telluride (ZnTe), CdTe, magnesium telluride (MgTe), manganese telluride (MnTe), beryllium telluride (BeTe) mercury telluride (HgTe), copper telluride (CuₓTe), and combinations thereof. These materials should also be understood to include the alloys thereof. For example, CdTe can be alloyed with zinc, magnesium, manganese, and/or sulfur to form cadmium zinc telluride, cadmium copper telluride, cadmium manganese telluride, cadmium magnesium telluride and combinations thereof. These materials may be actively doped to be p-type. Suitable dopants vary based on the semiconductor material. For CdTe, suitable p-type dopants include, without limitation, copper, gold, nitrogen, phosphorus, antimony, arsenic, silver, bismuth, sulfur and sodium. According to a particular embodiment, the p-type semiconductor layer 14 comprises doped ZnTe (for example, ZnTe:Cu or ZnTe:N) and has a thickness in a range of about 50-100 nm.

For certain configurations, the p-type semiconductor layer 14 and the substantially intrinsic semiconductor layer 16 form a compositionally graded layer transitioning from a p-type semiconductor material to substantially intrinsic CdTe. For example, this transition may occur over a distance of about 100 nm.

For the configurations shown in FIGS. 1-3, the n-type semiconductor layer 18 functions as a window layer. Namely, the window layer 18 is the junction-forming layer for the PV device 10, for the configurations shown in FIGS. 1-3. The addition of the window layer 18 induces an electric field that produces the photovoltaic effect. Non-limiting example materials for the n-type semiconductor layer 18 include Cadmium sulfide (CdS), Indium (III) sulfide (In₂S₃), Zinc sulfide (ZnS), Zinc Telluride (ZnTe), Zinc Selenide (ZnSe), Cadmium Selenide (CdSe), oxygenated cadmium sulfide (CdS:O), Copper oxide (Cu₂O), and Zn(O,H) and combinations thereof. According to a particular embodiment, the n-type semiconductor layer 18 comprises CdS and has a thickness in a range of about 50-100 nm. The atomic percent of cadmium in the cadmium sulfide, for certain configurations, is in a range of about 45-55 atomic percent, and more particularly, in a range of about 48-52 atomic percent.

For more specific configurations, the n-type semiconductor layer 18 comprises CdS, thereby providing a heterojunction interface between the substantially intrinsic semiconductor layer 16 and the CdS layer 18.

For particular configurations, the first electrically conductive layer 12 comprises a textured substrate. Non-limiting materials for the textured substrate 12 include nickel, nickel alloys, copper and copper alloys, and molybdenum and molybdenum alloys. As discussed in US 2007/0044832, Fritzemeier, "Photovoltaic Template," the textured substrate may be formed by deforming a substrate, and metal deformation techniques known to those skilled in the art can be used to produce sharp textures. Fritzemeier teaches that face centered cubic (fcc) metals, body centered cubic (bcc) metals and some alloys based on fcc metals can be used as the deformation substrate material, as they can be biaxially textured using well known rolling deformation and annealing processes. In particular, a "cube texture" can be achieved in fcc metals and alloys, using controlled rolling and annealing processes, such that the resulting deformation textured metal tapes possess textures that approach single crystal quality. An intermediate epitaxial film may be deposited on the textured substrate prior to deposition of the anticipated semiconductor film. Preferably, the texture of the substrate 12 is reproduced in the texture of the intermediate epitaxial film. Beneficially, the textured substrate 12 can be used as a template for growth of a substantially intrinsic semiconductor layer 16 with a median grain size of at least about five (5) µm. By using large grains, i.e., grains that are much larger than the thickness of the film, the electron-hole recombination at the defects associated with the grain-boundaries is reduced. If the quality of the grains is sufficiently high, carrier lifetimes in excess of one nanosecond can be achieved. Beneficially, by achieving longer carrier lifetimes, higher efficiencies can be achieved.

In one non-limiting example, the first electrically conductive layer 12 comprises a textured substrate (for example, a stamped nickel substrate) with a thin metal film (not shown) deposited on the stamped substrate to act as a barrier to prevent diffusion of the nickel into the subsequently deposited semiconductor layers and/or to enhance ohmic contact to the p-type semiconductor layer 14. The metal used to form the thin metal film should be selected to optimize the efficiency of the PV device 10 and preferably remain stable in the environment of CdTe. In one non-limiting example, a molybdenum (or alloy thereof) film is used. In other examples, a tantalum or tungsten (or alloys thereof) film is employed.

In addition, interface defects must also be reduced, in order to increase carrier lifetimes. To reduce interface defects in PV cell 10, the crystallographic alignment of the n-type semiconductor layer 18 with the substantially intrinsic CdTe layer 16 and the crystallographic alignment of the p-type semiconductor layer 14 with the substantially intrinsic semiconductor layer 16 need to be controlled. For example, the n-type semiconductor layer 18 and the substantially intrinsic semiconductor layer 16 should be substantially lattice matched (that is, their crystal structure and lattice constant should be sufficiently close) to permit the oriented growth of the n-type semiconductor layer 18 on the substantially intrinsic semiconductor layer 16, for the n-i-p configurations shown in FIGS. 1-3. However, other passivation techniques may also be applied. More critically, the p-type semiconductor layer 14 and the substantially intrinsic semiconductor layer 16 should be substantially lattice matched to permit the oriented growth of the substantially intrinsic semiconductor layer 16 on the p-type semiconductor layer 14, for the n-i-p configurations shown in FIGS. 1-3. In particular, the oriented growth of the intrinsic layer is more critical, and thus lattice matching at the interface between the p-type layer 14 and the intrinsic layer 16 is particularly important, for the for the n-i-p configurations shown in FIGS. 1-3. Similarly, for the p-i-n configurations shown in FIGS. 4 and 5, the oriented growth of the intrinsic layer is critical, and thus lattice matching at the interface between the n-type layer 18 and the intrinsic layer 16 is particularly important.

FIGS. 2, 3 and 5 illustrate additional optional features of PV cell 10. FIG. 2 is a schematic cross-sectional diagram of an example photovoltaic cell with an n-i-p structure and with a high resistance transparent conductive oxide (HRT) layer. For the example configuration shown in FIG. 2, the PV cell 10 further includes a high resistance transparent conductive oxide (HRT) layer 20 disposed between the n-type semiconductor layer 18 and the second electrically conductive layer 22. According to a particular embodiment, the thickness of the HRT layer 20 is in a range of about 50 nm to about 100 nm. Beneficially, the HRT layer 20 serves as a buffer layer and can increase the efficiency of the PV cell 10. Non-limiting examples of suitable materials for HRT layer 20 include tin dioxide (SnO₂), ZTO (zinc stannate), zinc-doped tin oxide (SnO₂:Zn) , zinc oxide (ZnO), indium oxide (In₂O₃), and combinations thereof. For the p-i-n configuration shown in FIG. 4, the HRT layer will not be present because a p-type window layer is used, with the n-type layer disposed in the bottom of the device.

FIG. 3 is a schematic cross-sectional diagram of an example photovoltaic cell with an insulating layer and a metal layer disposed between the first electrically conductive layer and the photovoltaic active layers. For the example configuration shown in FIG. 3, the PV cell 10 further includes an insulating layer 24 disposed between the first electrically conductive layer 12 and the p-type semiconductor layer 14. Non-limiting example materials for the insulating layer 24 include single crystal or polycrystalline insulators formed using materials, such as silicon dioxide (SiO₂), titanium dioxide (TiO₂) and SiOC. In order to achieve the desired grain structure within substantially intrinsic layer 16, the crystal structure of the insulator 24 should be controlled to transfer the texture from layer 12 to p-type layer 14. The configuration shown in FIG. 3 further includes a metal layer 28 disposed between the insulating layer 24 and the p-type semiconductor layer 14. The metal used to form layer 28 is selected, in part, to enhance the epitaxial growth of the subsequently deposited semiconductor layers 14 and 16. The metal layer 28 may comprise molybdenum, aluminum, chromium, gold, alloys thereof, or a combination/stack thereof. In one non-limiting example, the metal layer 28 comprises molybdenum or an alloy thereof. For this configuration, the metal layer 28 is used to make an ohmic contact with the p-type layer 14. The insulating layer 24 may act as a diffusion barrier to prevent diffusion of the metal (for example, nickel) from the contact 12 into the p-type material 14. In addition, the presence of the insulating layer 24 electrically isolates cells to facilitate monolithic integration of the PV cells 10 into a solar module (not shown).

For specific configurations, the photovoltaic cell 10 comprises a first electrically conductive layer 12 comprising a textured substrate 12, a p-type semiconductor layer 14, a substantially intrinsic semiconductor layer 16 with a median grain size of at least about five (5) µm and comprising cadmium and tellurium, and more particularly, comprising a material selected from the group consisting of cadmium telluride (CdTe), cadmium zinc telluride, cadmium sulfur telluride, cadmium manganese telluride, cadmium magnesium telluride and combinations thereof, an n-type semiconductor layer 18 and a second electrically conductive layer 22. For the n-i-p configuration shown in FIG. 1, the textured substrate 12 is disposed below the p-type semiconductor layer 14, the substantially intrinsic CdTe layer 16 is disposed between the p-type semiconductor layer 14 and the n-type semiconductor layer 18, and the n-type semiconductor layer 18 is disposed below the second electrically conductive layer 22. Each of the layers 12, 14, 16, 18 and 22 is discussed in detail above. For particular configurations, the substantially intrinsic semiconductor layer 16 has a thickness of less than three (3) µm, and more particularly less than two (2) µm, and comprises a plurality of grains, wherein at least ninety percent (90%) of the grains (in cross-sectional view) are characterized by a grain size of at least about five (5) µm. For more particular configurations, the ratio of the median grain size for the substantially intrinsic semiconductor layer (16) to the thickness of the substantially intrinsic layer is greater than two, and more particularly, greater than five, and still more particularly, greater than ten. Beneficially, by controlling this ratio, the electron-hole recombination at the defects associated with the grain-boundaries is reduced, thereby increasing the carrier lifetimes, which in turn enable higher efficiencies to be achieved. As discussed above, the p-type semiconductor layer 14 and the substantially intrinsic layer 16 may form a compositionally graded layer transitioning from a p-type semiconductor material to the substantially intrinsic semiconductor material, for example over a distance of about 100 nm. For the specific configuration shown in FIG. 3, the PV cell 10 further includes an insulating layer 24 disposed between the first electrically conductive layer 12 and the p-type semiconductor layer 14 and a metal layer 28 disposed between the insulating layer 24 and the p-type semiconductor layer 14. Similarly, for the configuration shown in FIG. 5, the first electrically conductive layer 12 is disposed below the n-type layer 18, the p-type layer 14 is disposed below the second electrically conductive layer 22, and the PV cell 10 further includes an insulating layer 24 disposed between the first electrically conductive layer 12 and the n-type layer 18, as well as a metal layer 28 disposed between the insulating layer 24 and the n-type layer 18.

Example processing steps for forming the PV cell 10 are described with reference to FIGS. 1-3. As discussed above, example materials for the first electrically conductive layer 12 include nickel, copper, molybdenum and alloys thereof. These materials may be deposited, for example by sputtering or evaporation. For particular embodiments, the first electrically conductive layer 12 comprises a textured substrate 12, which may be formed using known metal deformation techniques, such as but not limited to rolling deformation and annealing processes. As noted above, for certain configurations, the first electrically conductive layer 12 comprises a textured substrate 12 with a thin metal film (not shown) deposited thereon. The thin film may be deposited by sputtering or evaporation.

Referring to FIG. 1, the p-type layer 14 and the substantially intrinsic layer 16 are typically deposited on the substrate 12 by close space sublimation (CSS) or vapor phase transport. Alternatively, the p-type layer 14 and the substantially intrinsic layer 16 may be deposited using sputtering, evaporation (for example, e-beam or molecular beam epitaxy), or chemical vapor deposition.

The n-type layer 18 (see, for example, FIG. 1) is typically deposited by chemical bath (or vapor) deposition or electrochemical deposition. For example, chemical bath deposition may be used to deposit a CdS layer 18. Alternatively, the n-type layer 18 may also be deposited using sputtering. Dopants may be introduced within semiconductor layers 14, 16 and/or 18 using a variety of techniques, as discussed, for example, in commonly assigned US. Patent Application Ser. No. 12/415,267 "Layer for Thin Film Photovoltaics and a Solar Cell Made Therefrom," which is incorporated by reference herein in its entirety. The second electrically conductive layer (or back contact) 22 is typically deposited by sputtering a TCO layer 22.

Referring to FIG. 2, the optional HRT layer 20 is typically deposited using sputtering. Referring to FIG. 3, the optional metal layer 28 is typically deposited using sputtering or evaporation (for example, e-beam or molecular beam epitaxy). Optional insulator layer 24 (FIG. 3) and optional buffer layer 26 (see FIG. 4) are typically deposited by sputtering. Similar processing steps may be employed to form the p-i-n structure shown in FIGS. 4 and 5.

Beneficially, the PV devices of the present invention have increased open-circuit voltage relative to conventional CdTe based solar cells. Although the theoretical limit for materials with a bandgap in the 1.45 electron Volts range is slightly above 1 Volt (depending on the carrier concentration), this limit is not achieved in practice for conventional CdTe PV cells. V_{oc} is determined mainly by the effective carrier concentration of the CdTe layer. CdTe is typically a heavily self-compensating material, such that the p-type carrier concentration of a typical CdTe thin film layer is generally in the range of about 1x10¹⁴ to 3x10¹⁴ per cubic centimeter, allowing a maximum V_{OC} of about 0.85 Volts. Typical minority carrier lifetimes in these devices are less than about 1 nanosecond (ns). A combination of those two numbers will limit the V_{oc} for conventional CdTe solar cells to around 850 mV.

Grain boundaries play a dominant role in CdTe devices, as defects at grain-boundaries lower both the effective minority carrier lifetime and carrier density. Thus, the present invention improves upon the prior art devices by having large grains with enhanced carrier lifetime, while going to a p-I-n type of device with a reduction in lifetime diminishing grain-boundaries. Consequently, higher V_{OC} values can be achieved.

Although only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:
1. A photovoltaic cell comprising:
   a first electrically conductive layer;
   a p-type semiconductor layer;
   a substantially intrinsic semiconductor layer with a median grain size of at least about five (5) µm and comprising cadmium and tellurium;
   an n-type semiconductor layer; and
   a second electrically conductive layer,
   wherein the substantially intrinsic semiconductor layer is disposed between the p-type semiconductor layer and the n-type semiconductor layer.
2. The photovoltaic cell of Clause 1, wherein the substantially intrinsic semiconductor layer has a thickness of less than two (2) µm.
3. The photovoltaic cell of any preceding Clause, wherein the ratio of the median grain size for the substantially intrinsic semiconductor layer to the thickness of the substantially intrinsic semiconductor layer is greater than two.
4. The photovoltaic cell of any preceding Clause, wherein the substantially intrinsic semiconductor layer comprises a plurality of grains, and wherein at least ninety percent (90%) of the grains are characterized by a grain size of at least about five (5) µm.
5. The photovoltaic cell of any preceding Clause, wherein the second electrically conductive layer comprises a transparent conductive oxide.
6. The photovoltaic cell of any preceding Clause, wherein the first electrically conductive layer is disposed below the p-type semiconductor layer, and wherein the n-type semiconductor layer is disposed below the second electrically conductive layer.
7. The photovoltaic cell of any preceding Clause, further comprising a high resistance transparent conductive oxide (HRT) layer disposed between the n-type semiconductor layer and the second electrically conductive layer.
8. The photovoltaic cell of any preceding Clause, wherein the substantially intrinsic semiconductor layer comprises a material selected from the group consisting of cadmium telluride (CdTe), cadmium zinc telluride, cadmium sulfur telluride, cadmium manganese telluride, cadmium magnesium telluride and combinations thereof.
9. The photovoltaic cell of any preceding Clause, wherein the p-type semiconductor layer comprises a material selected from the group consisting of zinc telluride (ZnTe), CdTe, magnesium telluride (MgTe), manganese telluride (MnTe), beryllium telluride (BeTe) and combinations and alloys thereof.
10. The photovoltaic cell of any preceding Clause, wherein the n-type semiconductor layer comprises a material selected from the group consisting of CdS, In₂S₃, ZnS, amorphous or micro-crystalline silicon, Zn(O,H) and combinations thereof.
11. The photovoltaic cell of any preceding Clause, wherein the p-type semiconductor layer and the substantially intrinsic semiconductor layer form a compositionally graded layer transitioning from a p-type semiconductor material to a substantially intrinsic semiconductor material.
12. The photovoltaic cell of any preceding Clause, wherein the first electrically conductive layer comprises a textured substrate.
13. The photovoltaic cell of any preceding Clause, wherein the first electrically conductive layer is disposed below the p-type semiconductor layer, and wherein the n-type semiconductor layer is disposed below the second electrically conductive layer 22, the photovoltaic cell further comprising:
   an insulating layer disposed between the first electrically conductive layer and the p-type semiconductor layer; and
   a metal layer disposed between the insulating layer and the p-type semiconductor layer.
14. The photovoltaic cell of any preceding Clause, wherein the first electrically conductive layer is disposed below the n-type semiconductor layer, and wherein the p-type semiconductor layer is disposed below the second electrically conductive layer.
15. The photovoltaic cell of any preceding Clause, wherein the first electrically conductive layer comprises a textured substrate, the photovoltaic cell further comprising:
   an insulating layer disposed between the first electrically conductive layer and the n-type semiconductor layer; and
   a metal layer disposed between the insulating layer and the n-type semiconductor layer.
16. A photovoltaic cell comprising:
   a first electrically conductive layer comprising a textured substrate;
   a p-type semiconductor layer;
   a substantially intrinsic semiconductor layer with a median grain size of at least about five (5) µm and comprising cadmium and tellurium;
   an n-type semiconductor layer; and
   a second electrically conductive layer,
   wherein the substantially intrinsic semiconductor layer is disposed between the p-type semiconductor layer and the n-type semiconductor layer.
17. The photovoltaic cell of any preceding Clause, wherein the substantially intrinsic semiconductor layer has a thickness of less than two (2) µm and comprises a plurality of grains, and wherein at least ninety percent (90%) of the grains are characterized by a grain size of at least about five (5) µm.
18. The photovoltaic cell of any preceding Clause, wherein the ratio of the median grain size for the substantially intrinsic semiconductor layer to the thickness of the substantially intrinsic semiconductor layer is greater than two.
19. The photovoltaic cell of any preceding Clause, wherein the p-type semiconductor layer and the substantially intrinsic semiconductor layer form a compositionally graded layer transitioning from a p-type semiconductor material to the substantially intrinsic semiconductor material.
20. The photovoltaic cell of any preceding Clause, wherein the first electrically conductive layer is disposed below the p-type semiconductor layer, and wherein the n-type semiconductor layer is disposed below the second electrically conductive layer, the photovoltaic cell further comprising:
   an insulating layer disposed between the first electrically conductive layer and the p-type semiconductor layer; and
   a metal layer disposed between the insulating layer and the p-type semiconductor layer.
21. The photovoltaic cell of any preceding Clause, wherein the first electrically conductive layer is disposed below the n-type semiconductor layer, and wherein the p-type semiconductor layer is disposed below the second electrically conductive layer, the photovoltaic cell further comprising:
   an insulating layer disposed between the first electrically conductive layer and the n-type semiconductor layer; and
   a metal layer disposed between the insulating layer and the n-type semiconductor layer.
22. The photovoltaic cell of any preceding Clause, wherein the substantially intrinsic semiconductor layer comprises a material selected from the group consisting of cadmium telluride (CdTe), cadmium zinc telluride, cadmium sulfur telluride, cadmium manganese telluride, cadmium magnesium telluride and combinations thereof.

## Claims

1. A photovoltaic cell (10) comprising:
a first electrically conductive layer (12);
a p-type semiconductor layer (14);
a substantially intrinsic semiconductor layer (16) with a median grain size of at least about five (5) µm and comprising cadmium and tellurium;
an n-type semiconductor layer (18); and
a second electrically conductive layer (22),
wherein the substantially intrinsic semiconductor layer (16) is disposed between the p-type semiconductor layer and the n-type semiconductor layer.

2. The photovoltaic cell (10) of Claim 1, wherein the ratio of the median grain size for the substantially intrinsic semiconductor layer (16) to the thickness of the substantially intrinsic semiconductor layer is greater than two.

3. The photovoltaic cell (10) of any preceding Claim, wherein the substantially intrinsic semiconductor layer (16) comprises a plurality of grains, and wherein at least ninety percent (90%) of the grains are **characterized by** a grain size of at least about five (5) µm.

4. The photovoltaic cell (10) of any preceding Claim, wherein the second electrically conductive layer (22) comprises a transparent conductive oxide, wherein the first electrically conductive layer (12) is disposed below the p-type semiconductor layer (14), wherein the n-type semiconductor layer (18) is disposed below the second electrically conductive layer (22), the photovoltaic cell (10) further comprising a high resistance transparent conductive oxide (HRT) layer (20) disposed between the n-type semiconductor layer (18) and the second electrically conductive layer (22).

5. The photovoltaic cell (10) of any preceding Claim, wherein the substantially intrinsic semiconductor layer (16) comprises a material selected from the group consisting of cadmium telluride (CdTe), cadmium zinc telluride, cadmium sulfur telluride, cadmium manganese telluride, cadmium magnesium telluride and combinations thereof,
wherein the p-type semiconductor layer (14) comprises a material selected from the group consisting of zinc telluride (ZnTe), CdTe, magnesium telluride (MgTe), manganese telluride (MnTe), beryllium telluride (BeTe) and combinations and alloys thereof, and
wherein the n-type semiconductor layer (18) comprises a material selected from the group consisting of CdS, In₂S₃, ZnS, amorphous or micro-crystalline silicon, Zn(O,H) and combinations thereof.

6. The photovoltaic cell (10) of any preceding Claim, wherein the p-type semiconductor layer (14) and the substantially intrinsic semiconductor layer (16) form a compositionally graded layer transitioning from a p-type semiconductor material to a substantially intrinsic semiconductor material.

7. The photovoltaic cell (10) of any preceding Claim, wherein the first electrically conductive layer (12) comprises a textured substrate, wherein the first electrically conductive layer (12) is disposed below the p-type semiconductor layer (14), and wherein the n-type semiconductor layer (18) is disposed below the second electrically conductive layer 22, the photovoltaic cell further comprising:
an insulating layer (24) disposed between the first electrically conductive layer (12) and the p-type semiconductor layer (14); and
a metal layer (28) disposed between the insulating layer (24) and the p-type semiconductor layer (14).

8. The photovoltaic cell (10) of any preceding Claim, wherein the first electrically conductive layer (12) is disposed below the n-type semiconductor layer (18), and wherein the p-type semiconductor layer (14) is disposed below the second electrically conductive layer (22), wherein the first electrically conductive layer (12) comprises a textured substrate, the photovoltaic cell further comprising:
an insulating layer (24) disposed between the first electrically conductive layer (12) and the n-type semiconductor layer (18); and
a metal layer (28) disposed between the insulating layer (24) and the n-type semiconductor layer (18).

9. A photovoltaic cell (10) comprising:
a first electrically conductive layer (12) comprising a textured substrate;
a p-type semiconductor layer (14);
a substantially intrinsic semiconductor layer (16) with a median grain size of at least about five (5) µm and comprising cadmium and tellurium;
an n-type semiconductor layer (18); and
a second electrically conductive layer (22),
wherein the substantially intrinsic semiconductor layer is disposed between the p-type semiconductor layer and the n-type semiconductor layer,
wherein the substantially intrinsic semiconductor layer (16) has a thickness of less than two (2) µm and comprises a plurality of grains, wherein at least ninety percent (90%) of the grains are **characterized by** a grain size of at least about five (5) µm, and
wherein the substantially intrinsic semiconductor layer (16) comprises a material selected from the group consisting of cadmium telluride (CdTe), cadmium zinc telluride, cadmium sulfur telluride, cadmium manganese telluride, cadmium magnesium telluride and combinations thereof.

10. The photovoltaic cell (10) of Claim 9, wherein the first electrically conductive layer (12) is disposed below the n-type semiconductor layer (18), and wherein the p-type semiconductor layer (14) is disposed below the second electrically conductive layer (22), the photovoltaic cell (10) further comprising:
an insulating layer (24) disposed between the first electrically conductive layer (12) and the n-type semiconductor layer (18); and
a metal layer (28) disposed between the insulating layer (24) and the n-type semiconductor layer (18).
